# EUROPEAN PATENT APPLICATION

(11) **EP 4 786 259 A1**
(43) Date of publication of application: **05.08.2026**
(21) Application number: 25225401.6
(22) Date of filing: 19.12.2025
(51) Int. Cl.: B60L 53/22, B60L 53/302

(54) **POWER CONVERSION UNIT**

(30) Priority: 29.01.2025 JP 2025013218
(71) Applicant: AISIN CORPORATION, Aichi 448-8650 (JP)
(72) Inventor: YAMAMOTO, Yusuke, Aichi, 448-8650 (JP); TAKAHASHI, Ryohei, Aichi, 448-8650 (JP)
(74) Representative: Kramer Barske Schmidtchen Patentanwälte PartG mbB

(57) **Abstract**

A power conversion unit (100) performing power conversion for a vehicle drive device (TA) including a rotary electrical machine (M) being a drive source of a vehicle (V) includes: a power conversion circuit (1) including at least one of an inverter circuit (11) performing conversion between DC power and AC power between the rotary electrical machine (M) and an in-vehicle power storage device (B), a DC voltage conversion circuit (12) performing voltage conversion of DC power of the in-vehicle power storage device (B), and a charging circuit (13) supplying power of an external power supply (PS) to the in-vehicle power storage device (B) to charge the in-vehicle power storage device (B); a cooling device (2) cooling the power conversion circuit (1); and a case (3) accommodating the power conversion circuit (1) and the cooling device (2). A driving support arithmetic processing device (4) performing arithmetic processing for supporting driving of the vehicle (V) is disposed in the case (3). The driving support arithmetic processing device (4) is cooled by the cooling device (2).

## Description

### TECHNICAL FIELD

The present disclosure relates to a power conversion unit that performs power conversion for a vehicle drive device including a rotary electrical machine that is a drive source of a vehicle.

### BACKGROUND DISCUSSION

In recent years, technology development for electrification of a vehicle and supporting driving operation of the vehicle has been actively conducted. An electrified vehicle is generally equipped with a power conversion unit that converts power of a power supply such as an in-vehicle power storage device into DC power or AC power having a voltage of an appropriate magnitude for use by an in-vehicle apparatus operated by power of a rotary electrical machine or the like.

In addition, the function of supporting the driving operation of the vehicle is realized, for example, by mounting, on the vehicle, a driving support arithmetic processing device that generates a control signal for supporting the driver's driving operation. Specifically, the driving support arithmetic processing device generates a control signal for supporting the operation of the vehicle on the basis of the driver's driving operation and information received from a sensor that observes the situation of the vehicle. Then, by supplying the generated control signal to the power conversion unit and each in-vehicle apparatus that receives power supply from the power conversion unit, each in-vehicle apparatus performs operation of supporting the driving operation of the vehicle.

A technology related to a driving support arithmetic processing device is disclosed in, for example, JP 2020-170790 A. Hereinafter, in the description of the background art, reference signs and names in JP 2020-170790 A are cited in parentheses.

JP 2020-170790 A discloses a driving support arithmetic processing device (SoC37) that processes a signal received from a sensor unit (camera module).

However, since the driving support arithmetic processing device (SoC37) disclosed in JP 2020-170790 A generally generates a large amount of heat, it is necessary to install a cooling device (heat conducting member 42) for cooling the driving support arithmetic processing device. Furthermore, since a power conversion unit for a vehicle generally generates a large amount of heat, it is necessary to include a cooling device for cooling the power conversion unit. The vehicle is easily increased in size by providing the cooling device in each of the driving support arithmetic processing device and the power conversion unit.

Therefore, it is desired to realize a power conversion unit that easily downsizes the entire vehicle.

A need thus exists for a power conversion unit which is not susceptible to the drawback mentioned above.

### SUMMARY

A power conversion unit according to the present disclosure performing power conversion for a vehicle drive device including a rotary electrical machine that is a drive source of a vehicle, the power conversion unit including: a power conversion circuit including at least one of an inverter circuit that performs conversion between DC power and AC power between the rotary electrical machine and an in-vehicle power storage device, a DC voltage conversion circuit that performs voltage conversion of DC power of the in-vehicle power storage device, and a charging circuit that supplies power of an external power supply to the in-vehicle power storage device to charge the in-vehicle power storage device; a cooling device that cools the power conversion circuit; and a case that accommodates the power conversion circuit and the cooling device, a driving support arithmetic processing device that performs arithmetic processing for supporting driving of the vehicle being disposed in the case, and the driving support arithmetic processing device being cooled by the cooling device.

According to the present configuration, the driving support arithmetic processing device can also be cooled using the cooling device for cooling the power conversion circuit. Therefore, it is easy to reduce the size and cost of the vehicle as compared with a configuration in which a driving support arithmetic processing device is provided in a unit different from a power conversion unit. In addition, since the driving support arithmetic processing device and the power conversion circuit are disposed in the same case, the transmission path of the control signal generated by the driving support arithmetic processing device to the power conversion circuit is easily simplified, and the delay in transmission of the control signal is easily reduced.

Further features and advantages of the technology according to the present disclosure will become more apparent from the following description of exemplary and non-limiting embodiments, which will be described with reference to the drawings.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a diagram schematically illustrating a vehicle on which a power conversion unit of Embodiment 1 is mounted;
Fig. 2 is a three-dimensional view schematically illustrating a configuration disposed in a case of the power conversion unit of Embodiment 1;
Fig. 3 is a plan view of the configuration illustrated in Fig. 2;
Fig. 4 is a bottom view of the configuration illustrated in Fig. 2;
Fig. 5 is a three-dimensional view schematically illustrating a configuration disposed in a case of a power conversion unit of Embodiment 2;
Fig. 6 is a plan view of the configuration illustrated in Fig. 5; and
Fig. 7 is a bottom view of the configuration illustrated in Fig. 5.

### DETAILED DESCRIPTION

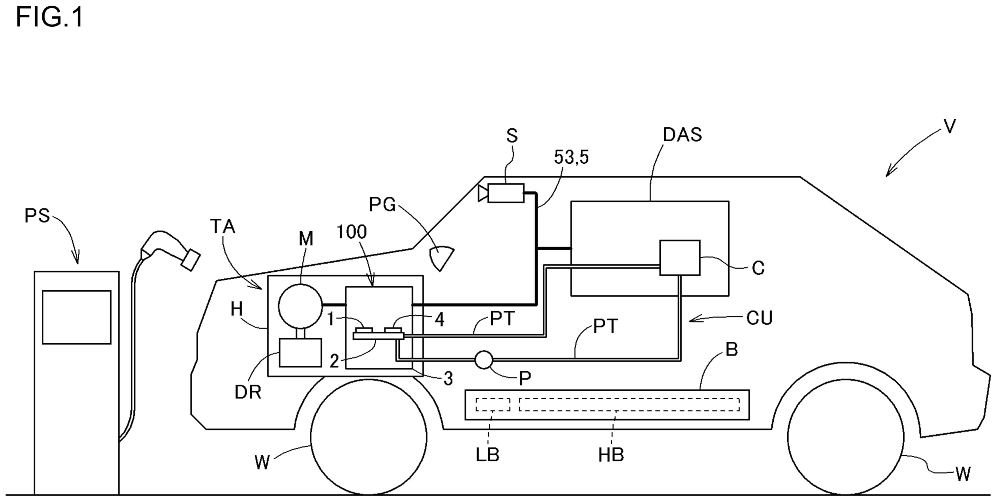

An outline of a power conversion unit 100 according to an embodiment will be described with reference to Fig. 1. As illustrated in Fig. 1, the power conversion unit 100 is mounted on a vehicle V. Examples of such a vehicle V include a vehicle V having an internal combustion engine, a motor, a rotary electrical machine M, or a combination thereof as a drive source. Specifically, the vehicle V is a gasoline vehicle, a diesel vehicle, an electric vehicle, a hybrid vehicle, a fuel cell vehicle, or another vehicle.

In the present embodiment, the vehicle V includes an in-vehicle power storage device B, a vehicle drive device TA that drives the vehicle V, a driving support unit DAS for supporting driving operation of the vehicle V, the power conversion unit 100, and a temperature adjustment unit CU. The in-vehicle power storage device B supplies power to electrical apparatuses (in-vehicle apparatuses) mounted on the vehicle V including the vehicle drive device TA and the driving support unit DAS. The power conversion unit 100 performs power conversion for the in-vehicle apparatuses including the vehicle drive device TA. In the present embodiment, the power conversion unit 100 is mounted on the vehicle V including the in-vehicle power storage device B that can be charged by an external power supply PS. Fig. 1 illustrates the vehicle V including a power supply port PG electrically connectable to a plug included in the external power supply PS. The power conversion unit 100 performs power conversion for converting power stored in the in-vehicle power storage device B into DC power or AC power having a voltage of an appropriate magnitude for the in-vehicle apparatus to use. In addition, the power conversion unit 100 of the present embodiment also performs power conversion for converting power supplied from the external power supply PS into DC power having a voltage of an appropriate magnitude for the in-vehicle power storage device B to store.

In the present embodiment, the in-vehicle power storage device B includes a high-voltage battery HB and a low-voltage battery LB.

The high-voltage battery HB is a DC power supply including a rechargeable secondary battery such as a lithium ion battery, an electric double layer capacitor, or the like, and is configured by integrating a plurality of battery cells, for example. The rated voltage of the high-voltage battery HB is often set to about 200 volts to 800 volts, and is electrically connected to the rotary electrical machine M or the like to be described later. The high-voltage battery HB is configured to be chargeable with power supplied from an in-vehicle power generation device or the external power supply PS such as an AC power supply having a rated voltage of about 100 to 240 volts, a DC power supply for rapid charging having a rated voltage of 200 to 400 volts or more, or another power supply. In the vehicle V illustrated in Fig. 1, the external power supply PS is electrically connected to the high-voltage battery HB through the power conversion unit 100 by connecting the plug included in the external power supply PS to the power supply port PG provided on a side surface of the vehicle V. The power conversion unit 100 converts the power of the external power supply PS into DC power having a voltage at which the high-voltage battery HB can be charged.

The low-voltage battery LB is a DC power supply having a configuration similar to that of the high-voltage battery HB and a rated voltage set to be lower than that of the high-voltage battery HB, and is electrically connected to a microcomputer, a system on chip (SoC), and other processors. The rated voltage of the low-voltage battery LB is often set to, for example, about 12 to 24 volts. In the present embodiment, the low-voltage battery LB is configured to be chargeable from the high-voltage battery HB through a DC voltage conversion circuit 12 (details will be described later).

In the present embodiment, the vehicle drive device TA is a driving force generation source that drives an output member (not illustrated) that transmits motive power by rotating, and is a device for transmitting the driving force to the output member. Examples of the output member driven by the vehicle drive device TA include an axle of a wheel W, an input shaft of the in-vehicle power generation device, and the like.

The vehicle drive device TA includes at least the rotary electrical machine M. The rotary electrical machine M generates a driving force for rotating the output member. In the present embodiment, the rotary electrical machine M is electrically connected to the in-vehicle power storage device B through the power conversion unit 100, and functions as a drive source that generates a driving force for rotating the wheels W using power stored in the in-vehicle power storage device B. Specifically, the rotary electrical machine M at least has a function as a motor (electric motor) that generates motive power from AC power converted by the power conversion unit 100 from DC power supplied from the high-voltage battery HB. The rotary electrical machine M may also have a function as a generator (dynamo) that generates power from motive power transmitted from the wheels W. In this case, the rotary electrical machine M generates AC power from the motive power transmitted from the wheels W. Then, the AC power generated by the rotary electrical machine M is converted into DC power by the power conversion unit 100, and the high-voltage battery HB is charged with the DC power.

In the present embodiment, the vehicle drive device TA further includes a motive power transmission mechanism DR that transmits motive power between the rotary electrical machine M and the output member. Specifically, the rotary electrical machine M is drivingly coupled to the output member through the motive power transmission mechanism DR. Here, in the present application, the term "drivingly coupled" refers to a state in which two rotary elements are coupled so that driving force can be transmitted therebetween. The state includes a state in which the two rotary elements are coupled so as to rotate integrally, or a state in which the two rotary elements are coupled so that driving force can be transmitted therebetween through one or more transmission members. As such transmission members, various members that transmit rotation at the same speed or at a variable speed, such as a shaft, a gear mechanism, a belt, and a chain are included. Note that as the transmission member, an engagement device that selectively transmits rotation and driving force, for example, a friction engagement device, a meshing engagement device, or the like may be included. In the example illustrated in Fig. 1, the rotary electrical machine M and the motive power transmission mechanism DR are accommodated in a housing H.

In the present embodiment, the driving support unit DAS includes a driving support sensor S that observes internal and external states of the vehicle V, and a driving support arithmetic processing device (first arithmetic processing device C). The first arithmetic processing device C performs arithmetic processing for performing control necessary for performing driving support for the driver on the in-vehicle apparatus on the basis of information obtained from the driving support sensor S. Here, driving support includes assisting the driver's driving operation and automated driving in which the vehicle V autonomously travels without the driver's driving operation. Further, assisting the driver's driving operation includes display operation of displaying information regarding the situation inside and outside the vehicle V on a display device (not illustrated) included in the vehicle V. The display device included in the vehicle V includes, for example, an instrument panel, mirrors such as a rearview mirror and a side mirror, and a display unit of an in-vehicle car navigation system. In addition, assisting the driver's driving operation includes driving assistance operation such as stopping the vehicle V in an emergency.

For example, a camera illustrated in Fig. 1 is often used as the driving support sensor S. The camera illustrated in Fig. 1 images the front of the vehicle V. In addition, as the first arithmetic processing device C, for example, a processor having a relatively high processing capability such as an SoC is often used. The driving support unit DAS illustrated in Fig. 1 generates a control signal for the first arithmetic processing device C to control the vehicle drive device TA and a steering unit (not illustrated) that controls the direction of the vehicle V on the basis of image information obtained from the camera as the driving support sensor S. By using such a control signal, the vehicle V illustrated in Fig. 1 can perform automated driving.

The temperature adjustment unit CU includes a circulation path PT that circulates in the vehicle V via the in-vehicle apparatus (temperature management target apparatus) that requires temperature adjustment, a pump P, and a heat exchanger (not illustrated). The circulation path PT includes a pipe line through which a refrigerant that performs heat transfer with the temperature management target apparatus flows. The circulation path PT is in direct close contact with the temperature management target apparatus or in indirect contact with the temperature management target apparatus with a heat transfer sheet, a heat transfer resin, or another heat transfer member interposed therebetween to transfer heat between the refrigerant flowing inside the circulation path PT and the temperature management target apparatus. In the present embodiment, the refrigerant cools the in-vehicle apparatus that generates a large amount of heat as the temperature management target apparatus. Therefore, cooling water for cooling the temperature management target apparatus is used as the refrigerant. The circulation path PT illustrated in Fig. 1 is configured to pass through the vehicle drive device TA, the power conversion unit 100, and the first arithmetic processing device C included in the driving support unit DAS. The pump P is disposed at an intermediate position in the circulation path PT to circulate the refrigerant in the circulation path PT. The heat exchanger radiates heat of the refrigerant to the outside of the vehicle V.

### [Embodiment 1]

Details of the power conversion unit 100 of Embodiment 1 will be described with reference to Figs. 1 to 4.

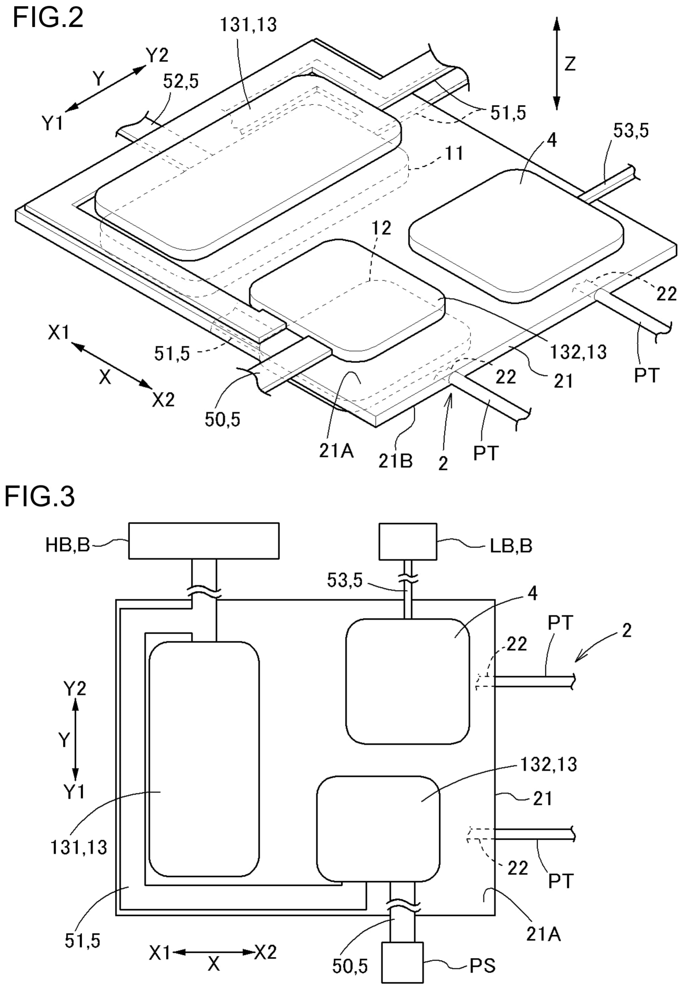

As illustrated in Figs. 1 and 2, the power conversion unit 100 includes a power conversion circuit 1, a cooling device 2 for cooling the power conversion circuit 1, and a case 3. The power conversion circuit 1 performs at least one of power conversion between the in-vehicle power storage device B and the rotary electrical machine M and power conversion between the external power supply PS and the in-vehicle power storage device B. The case 3 accommodates the power conversion circuit 1 and the cooling device 2.

As illustrated in Figs. 2 to 4, the power conversion circuit 1 includes at least one of an inverter circuit 11, a DC voltage conversion circuit 12, and a charging circuit 13. In the present embodiment, the power conversion circuit 1 includes the inverter circuit 11 and the charging circuit 13. In addition, in the present embodiment, the power conversion circuit 1 also includes the DC voltage conversion circuit 12.

The inverter circuit 11 converts DC power and AC power between the rotary electrical machine M and the in-vehicle power storage device B. In the present embodiment, the inverter circuit 11 converts DC power supplied from the high-voltage battery HB into AC power. The DC power supplied from the high-voltage battery HB to the inverter circuit 11 is converted by the inverter circuit 11 into AC power based on a control signal generated by an arithmetic processing device including the first arithmetic processing device C and a second arithmetic processing device 4 to be described later. Specifically, the inverter circuit 11 is a circuit including a switching element such as an insulated gate bipolar transistor (IGBT) or a power metal oxide semiconductor field effect transistor (MOSFET).

The DC voltage conversion circuit 12 performs voltage conversion of DC power of the in-vehicle power storage device B. In the present embodiment, the DC voltage conversion circuit 12 performs power conversion for stepping down DC power stored in the high-voltage battery HB. The DC power converted by the DC voltage conversion circuit 12 is supplied to the low-voltage battery LB and the in-vehicle apparatus that operates with DC power having a voltage lower than that of the DC power stored in the high-voltage battery HB.

The charging circuit 13 supplies the power of the external power supply PS to the in-vehicle power storage device B to charge the in-vehicle power storage device B. In the present embodiment, the charging circuit 13 performs power conversion for converting AC power supplied from the external power supply PS into DC power and supplying the DC power to the in-vehicle power storage device B. In addition, the charging circuit 13 may perform power conversion for supplying DC power from the external power supply PS to the in-vehicle power storage device B without converting the voltage thereof, power conversion for converting the voltage of DC power from the external power supply PS and supplying the DC power to the in-vehicle power storage device B, or other power conversion for rapid charging.

In the present embodiment, the charging circuit 13 includes a charging component 131 and a junction box 132. In the present embodiment, the charging component 131 converts AC power supplied from the external power supply PS into DC power that can be stored in the high-voltage battery HB. The junction box 132 has a function as a repeater that aggregates wirings of the high-voltage battery HB including a plurality of battery cells. In the present embodiment, the junction box 132 is connected to both the wiring from the high-voltage battery HB and the wiring from the charging component 131, and switches the wiring through which the current of the power supplied from the external power supply PS flows according to the type of power supplied from the external power supply PS. Specifically, in a case where the external power supply PS is an AC power supply, the junction box 132 electrically connects the wiring leading to the charging component 131 and the external power supply PS. On the other hand, in a case where the external power supply PS is a DC power supply for rapid charging, the junction box 132 electrically connects the wiring leading to the high-voltage battery HB and the external power supply PS.

As illustrated in Fig. 1, the driving support arithmetic processing device (second arithmetic processing device 4) that performs arithmetic processing for supporting driving of the vehicle V is disposed in the case 3. The second arithmetic processing device 4 performs processing equivalent to that of the first arithmetic processing device C. Here, performing processing equivalent to that of the first arithmetic processing device C means exhibiting a function sufficient for securing redundancy of the first arithmetic processing device C. Therefore, similarly to the first arithmetic processing device C, a processor having a relatively high processing capability such as an SoC is often used as the second arithmetic processing device 4. According to the present configuration, a power supply system for supplying power to the first arithmetic processing device C and a power supply system for supplying power to the second arithmetic processing device 4 can be divided so as to be independent from each other. Therefore, as compared with a case where the first arithmetic processing device C and the second arithmetic processing device 4 share the power supply system, it is possible to reduce the risk that both the first arithmetic processing device C and the second arithmetic processing device 4 lose their functions at the same time.

In the present embodiment, the case 3 is accommodated in the housing H included in the vehicle drive device TA. According to the present configuration, it is not necessary to secure a space for installing the power conversion unit 100 separately from the vehicle drive device TA, and thus it is easy to downsize the entire vehicle V. In addition, also in the case of assembling the vehicle V, the power conversion unit 100 can be fixed so as to be fitted in the structure of the vehicle V only by fixing the vehicle drive device TA to the structure of the vehicle V. Therefore, according to the present configuration, the work of assembling the vehicle V can be simplified.

The second arithmetic processing device 4 is configured to be cooled by the cooling device 2. The cooling device 2 is connected to the circulation path PT of the temperature adjustment unit CU, and cools the second arithmetic processing device 4 by the refrigerant flowing through the circulation path PT. In the present embodiment, in addition to the second arithmetic processing device 4, the power conversion circuit 1 is also cooled by the cooling device 2. According to the present configuration, the configuration of the cooling system provided in the entire vehicle V can be simplified as compared with a case where the power conversion circuit 1 is cooled by a cooling circuit different from the cooling circuit that cools the second arithmetic processing device 4. In addition, according to the present configuration, the first arithmetic processing device C, the power conversion circuit 1, and the second arithmetic processing device 4 are cooled by the common temperature adjustment unit CU. Therefore, also in this respect, the configuration of the cooling system included in the entire vehicle V can be simplified as compared with a case where the first arithmetic processing device C, the power conversion circuit 1, and the second arithmetic processing device 4 are cooled by different cooling circuits.

As illustrated in Figs. 2 to 4, the cooling device 2 includes a cooling member 21 in which a flow path 22 through which the refrigerant flows is formed. Specifically, the cooling member 21 is a plate-shaped member including the flow path 22 therein. The flow path 22 is connected to the circulation path PT such that the refrigerant moves back and forth between the circulation path PT and the flow path 22. In the present embodiment, although not illustrated in detail, the flow path 22 is formed so as to meander inside the cooling member 21, and includes an opening (not illustrated) opening to a side of the cooling member 21. The circulation path PT is connected to the opening of the flow path 22.

In the present embodiment, the cooling member 21 includes a first surface 21A and a second surface 21B facing a side opposite to the first surface 21A. The members attached to the first surface 21A and the second surface 21B perform heat transfer with the refrigerant flowing through the flow path 22. The member is attached to the first surface 21A or the second surface 21B in a heat-transferable state. For example, the member may be fixed to the first surface 21A or the second surface 21B so as to be in direct contact with the cooling member 21, or may be fixed to the first surface 21A or the second surface 21B with a heat transfer sheet, a heat transfer resin, or another heat transfer member interposed therebetween.

The respective configurations included in the second arithmetic processing device 4 and the power conversion circuit 1 are disposed on one of the first surface 21A and the second surface 21B of the cooling member 21. Hereinafter, the positions of the respective configurations included in the second arithmetic processing device 4 and the power conversion circuit 1 with respect to the cooling member 21 will be described. For convenience of description of the position with respect to the cooling member 21, in the present specification, a direction along a direction orthogonal to the first surface 21A is referred to as an orthogonal direction Z. As viewed in the orthogonal direction Z, a direction along one side forming the first surface 21A is referred to as an in-surface direction X. One side in the in-surface direction X is referred to as an in-surface direction first side X1, and the other side in the in-surface direction X is referred to as an in-surface direction second side X2. A direction intersecting the in-surface direction X as viewed in the orthogonal direction Z is referred to as a surface width direction Y. One side in the surface width direction Y is referred to as a surface width direction first side Y1, and the other side in the surface width direction Y is referred to as a surface width direction second side Y2.

The respective configurations included in the second arithmetic processing device 4 and the power conversion circuit 1 are arranged on the first surface 21A and the second surface 21B of the cooling member 21 in consideration of electromagnetic noise generated by the respective configurations included in the power conversion circuit 1 during operation. This is because the electromagnetic noise may become a noise source that malfunctions the second arithmetic processing device 4. Specifically, electromagnetic noise reaches a member affected by the electromagnetic noise from a member serving as a generation source of the electromagnetic noise by following a transmission path specific to the electromagnetic noise. Examples of the transmission path of electromagnetic noise include a path passing through the surface or the inside of a member having conductivity, and paths radiating into the space. The transmission path of electromagnetic noise is not necessarily a linear path, and is, for example, a path that is folded back along the back surface from the front surface of the plate-shaped member. In addition, the magnitude of electromagnetic noise at the time of reaching the member affected by the electromagnetic noise is not determined only by the distance from the member affected by the electromagnetic noise to the electromagnetic noise generation source. For example, the magnitude of electromagnetic noise at the time of reaching a member affected by the electromagnetic noise is also affected by factors such as the presence or absence of a filter or a shield for reducing the influence of the electromagnetic noise.

The second arithmetic processing device 4 is arranged at a position farther from the inverter circuit 11 than from the charging circuit 13 with respect to the transmission path length of the electromagnetic noise. The transmission path length of electromagnetic noise is the length of the path followed by the electromagnetic noise transmitted from the member serving as the electromagnetic noise generation source to the member affected by the electromagnetic noise. Regarding the transmission path length of electromagnetic noise, the length from the second arithmetic processing device 4 to the charging circuit 13 can be made smaller than the length from the second arithmetic processing device 4 to the inverter circuit 11 because the operation timing of the second arithmetic processing device 4 is different from the operation timing of the charging circuit 13. That is, the second arithmetic processing device 4 mainly operates while the vehicle V is traveling, and the inverter circuit 11 also operates while the vehicle V is traveling. On the other hand, the charging circuit 13 operates when the in-vehicle power storage device B is charged, in other words, when the vehicle V is stopped. Therefore, the likelihood that the second arithmetic processing device 4 is affected by the electromagnetic noise generated from the charging circuit 13 is low. According to the present configuration, since the second arithmetic processing device 4 and the power conversion circuit 1 can be efficiently arranged on the cooling member 21, the entire power conversion unit 100 can be easily downsized.

In a case where the power conversion circuit 1 includes the DC voltage conversion circuit 12 as in the present embodiment, the second arithmetic processing device 4 is preferably arranged at a position farther from the DC voltage conversion circuit 12 than from the charging circuit 13 with respect to the transmission path length of the electromagnetic noise. This is because the time when the DC voltage conversion circuit 12 operates also overlaps with the time when the second arithmetic processing device 4 operates, similarly to the inverter circuit 11. Also with the present configuration, since the second arithmetic processing device 4 and the power conversion circuit 1 can be efficiently arranged on the cooling member 21, the entire power conversion unit 100 can be easily downsized.

In the present embodiment, as illustrated in Figs. 2 and 3, the second arithmetic processing device 4 is attached to the first surface 21A of the cooling member 21. In the present embodiment, the first surface 21A has a rectangular shape including a side along the in-surface direction X and a side along the surface width direction Y as viewed in the orthogonal direction Z. The second arithmetic processing device 4 is disposed at a corner of the first surface 21A on the in-surface direction second side X2 and the surface width direction second side Y2.

In the present embodiment, the charging circuit 13 is disposed on the first surface 21A. In the example illustrated in Fig. 1, the charging component 131 and the junction box 132 are disposed on the first surface 21A. The charging component 131 is arranged on the in-surface direction first side X1 at an interval from the second arithmetic processing device 4, the interval sufficiently securing the transmission path length of electromagnetic noise. The junction box 132 is arranged on the surface width direction first side Y1 at an interval from the second arithmetic processing device 4, the interval sufficiently securing the transmission path length of electromagnetic noise. Here, the interval sufficiently securing the transmission path length of electromagnetic noise refers to an interval from the second arithmetic processing device 4 necessary for sufficiently reducing the likelihood that the second arithmetic processing device 4 malfunctions due to the electromagnetic noise. In the following description, arrangement at an interval from the second arithmetic processing device 4, the interval sufficiently securing the transmission path length of electromagnetic noise will be simply described as arrangement at a sufficient interval from the second arithmetic processing device 4.

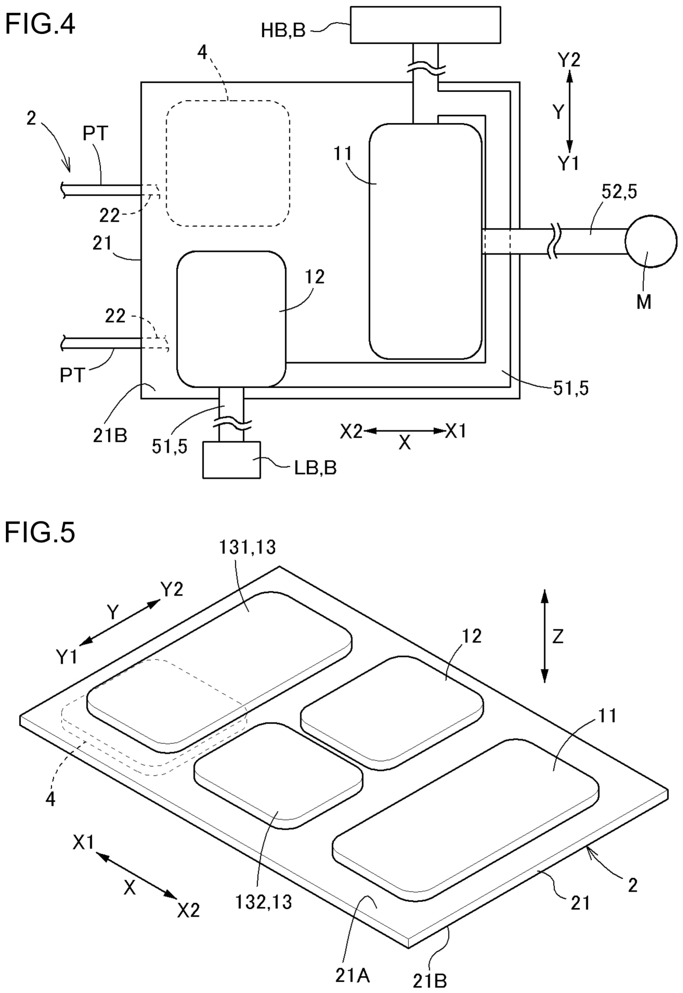

In the present embodiment, as illustrated in Figs. 2 and 4, the inverter circuit 11 and the DC voltage conversion circuit 12 are attached to the second surface 21B of the cooling member 21. In the present embodiment, similarly to the first surface 21A, the second surface 21B has a rectangular shape including a side along the in-surface direction X and a side along the surface width direction Y as viewed in the orthogonal direction Z. The inverter circuit 11 is arranged at a position closer to the in-surface direction first side X1 on the second surface 21B. The DC voltage conversion circuit 12 is arranged at a corner of the second surface 21B on the in-surface direction second side X2 and the surface width direction first side Y1 as viewed in the orthogonal direction Z.

Preferably, the inverter circuit 11 and the DC voltage conversion circuit 12 are arranged at positions not overlapping with the second arithmetic processing device 4 as viewed in the orthogonal direction Z. In the present embodiment, the power conversion circuit 1 is not arranged at a position on the second surface 21B overlapping with the arrangement position of the second arithmetic processing device 4 as viewed in the orthogonal direction Z. Therefore, it is easy to suppress the magnitude of the electromagnetic noise reaching the second arithmetic processing device 4 that is operating to be low.

The power conversion unit 100 further includes a connection structure 5 for electrically connecting the second arithmetic processing device 4 and the power conversion circuit 1 to the in-vehicle apparatuses arranged at various positions in the vehicle V. The connection structure 5 tends to be part of the transmission path of electromagnetic noise from the power conversion circuit 1 and other electromagnetic noise generation sources. Therefore, in the present embodiment, the connection structure 5 is configured to reduce the magnitude of the electromagnetic noise reaching the second arithmetic processing device 4 through the connection structure 5.

The connection structure 5 includes a first connection path 51 and a second connection path 52 that connect the in-vehicle apparatuses and the power conversion unit 100, and a third connection path 53 including a signal line and a power line connected to the second arithmetic processing device 4. The first connection path 51 electrically connects the power conversion circuit 1 and the in-vehicle power storage device B. The second connection path 52 electrically connects the power conversion circuit 1 and the rotary electrical machine M. In the present embodiment, the first connection path 51 and the second connection path 52 include bus bars.

The first connection path 51 is likely to be a transmission path of the electromagnetic noise generated by the power conversion circuit 1, and the second connection path 52 is likely to be a transmission path of the electromagnetic noise generated by both the rotary electrical machine M and particularly the inverter circuit 11 in the power conversion circuit 1. Therefore, regarding the transmission path length of electromagnetic noise, when the third connection path 53 is arranged close to the first connection path 51 and the second connection path 52, the signal and power transmitted to the second arithmetic processing device 4 through the third connection path 53 may be affected by the electromagnetic noise passing through the first connection path 51 and the second connection path 52.

In order to suppress transmission of electromagnetic noise transmitted along the first connection path 51 and the second connection path 52 to the third connection path 53, the first connection path 51 and the second connection path 52 are arranged apart from the third connection path 53 by a set distance set in advance or more. As the set distance, for example, a distance larger than a distance required for electrically insulating each of the first connection path 51 and the second connection path 52 from the third connection path 53 is set. Hereinafter, the arrangement positions of the first connection path 51 and the second connection path 52 with respect to the second arithmetic processing device 4 and the third connection path 53 will be described in detail.

In the present embodiment, as illustrated in Fig. 3, the first connection path 51 and the third connection path 53 are arranged on the first surface 21A.

As illustrated in Fig. 3, the first connection path 51 arranged on the first surface 21A electrically connects the charging component 131 and the junction box 132 to the high-voltage battery HB. In the present embodiment, the first connection path 51 is arranged at a position farther from the second arithmetic processing device 4 than the shortest distance from the charging circuit 13 to the second arithmetic processing device 4 as viewed in the orthogonal direction Z. According to the present configuration, the first connection path 51 is arranged at a position farther from the second arithmetic processing device 4 than from the charging circuit 13 serving as an electromagnetic noise generation source. Therefore, electromagnetic noise is less likely to be transmitted from the first connection path 51 to the second arithmetic processing device 4.

Specifically, in the present embodiment, the first connection path 51 is arranged at a position farther from the second arithmetic processing device 4 than the shortest distance from the end of the charging component 131 on the in-surface direction second side X2 to the second arithmetic processing device 4. In addition, the first connection path 51 is arranged at a position farther from the second arithmetic processing device 4 than the shortest distance from the portion of the junction box 132 on the surface width direction second side Y2 to the second arithmetic processing device 4. In the example illustrated in Fig. 3, the first connection path 51 is arranged at a position surrounding both the charging component 131 and the junction box 132 from the in-surface direction first side X1 and the surface width direction first side Y1 as viewed in the orthogonal direction Z. Then, the first connection path 51 is arranged so as to pass through a path leading to the high-voltage battery HB via the region on the surface width direction second side Y2 with respect to the charging component 131.

In the present embodiment, the third connection path 53 is arranged at a position not overlapping with the first connection path 51 as viewed in the orthogonal direction Z. Therefore, it is easy to secure the large set distance between the first connection path 51 and the third connection path 53. In the example illustrated in Fig. 3, the third connection path 53 extends from the second arithmetic processing device 4 in a direction away from the charging circuit 13. According to the present configuration, it is possible to reduce the likelihood that the electromagnetic noise generated by the charging circuit 13 is transmitted from the third connection path 53 to the second arithmetic processing device 4. Specifically, the third connection path 53 extends from a portion of the second arithmetic processing device 4 on the surface width direction second side Y2 to the surface width direction second side Y2. Therefore, since the shortest distance from the third connection path 53 to the first connection path 51 is larger than the shortest distance from the charging circuit 13 to the second arithmetic processing device 4, the likelihood that the electromagnetic noise is transmitted from the first connection path 51 to the third connection path 53 can be reduced.

In the present embodiment, as illustrated in Fig. 4, the first connection path 51 and the second connection path 52 are arranged on the second surface 21B.

As illustrated in Fig. 4, the first connection path 51 arranged on the second surface 21B includes a path that electrically connects the inverter circuit 11 and the DC voltage conversion circuit 12 to the high-voltage battery HB and a path that electrically connects the DC voltage conversion circuit 12 to the low-voltage battery LB. Similarly to the first connection path 51 arranged on the first surface 21A, the first connection path 51 arranged on the second surface 21B is also arranged at a position farther from the second arithmetic processing device 4 than each of the shortest distances from the inverter circuit 11 and the DC voltage conversion circuit 12 to the second arithmetic processing device 4 as viewed in the orthogonal direction Z. According to the present configuration, the first connection path 51 is arranged at a position farther from the second arithmetic processing device 4 than the inverter circuit 11 and the DC voltage conversion circuit 12 serving as electromagnetic noise generation sources. Therefore, electromagnetic noise is less likely to be transmitted from the first connection path 51 to the second arithmetic processing device 4.

The first connection path 51 that connects the inverter circuit 11 and the DC voltage conversion circuit 12 to the high-voltage battery HB extends from a portion of the DC voltage conversion circuit 12 on the in-surface direction first side X1 to the in-surface direction first side X1 as viewed in the orthogonal direction Z. Then, the first connection path 51 is arranged at a position reaching the position on the surface width direction second side Y2 via the position on the surface width direction first side Y1 and the position on the in-surface direction first side X1 with respect to the inverter circuit 11. Furthermore, the first connection path 51 that connects the inverter circuit 11 and the DC voltage conversion circuit 12 to the high-voltage battery HB extends in the surface width direction Y from the position on the surface width direction second side Y2 with respect to the inverter circuit 11, a portion of the first connection path 51 on the surface width direction first side Y1 is connected to the inverter circuit 11, and a portion of the first connection path 51 on the surface width direction second side Y2 is connected to the high-voltage battery HB. On the other hand, the first connection path 51 that connects the DC voltage conversion circuit 12 to the low-voltage battery LB extends from the portion of the DC voltage conversion circuit 12 on the surface width direction first side Y1 toward the surface width direction first side Y1. According to the present configuration, the first connection path 51 is not arranged at a position overlapping with the position where the second arithmetic processing device 4 is arranged as viewed in the orthogonal direction Z. Therefore, it is possible to reduce the likelihood that electromagnetic noise whose transmission path is the first connection path 51 affects the operation of the second arithmetic processing device 4.

As illustrated in Fig. 4, the second connection path 52 arranged on the second surface 21B electrically connects the inverter circuit 11 to the rotary electrical machine M. In the present embodiment, the second connection path 52 is arranged at a position farther from the second arithmetic processing device 4 than the shortest distance from the inverter circuit 11 to the second arithmetic processing device 4 as viewed in the orthogonal direction Z. According to the present configuration, the second connection path 52 is arranged at a position farther from the second arithmetic processing device 4 than from the inverter circuit 11 serving as an electromagnetic noise generation source. Therefore, electromagnetic noise is less likely to be transmitted from the second connection path 52 to the second arithmetic processing device 4. Specifically, the second connection path 52 extends from the portion of the inverter circuit 11 on the in-surface direction first side X1 toward the in-surface direction first side X1. According to the present configuration, the second connection path 52 is not arranged at a position overlapping with the position where the second arithmetic processing device 4 is arranged as viewed in the orthogonal direction Z. Therefore, it is possible to reduce the likelihood that electromagnetic noise whose transmission path is the second connection path 52 affects the operation of the second arithmetic processing device 4.

Note that in the present embodiment, the first connection path 51 and the second connection path 52 overlap each other as viewed in the orthogonal direction Z. However, the influence of the electromagnetic noise passing through the first connection path 51 and the second connection path 52 on the second arithmetic processing device 4 caused by the fact that the first connection path 51 and the second connection path 52 overlap in the orthogonal direction Z is small enough not to cause malfunction of the second arithmetic processing device 4.

In the present embodiment, as illustrated in Fig. 3, the connection structure 5 further includes a charging path 50 for electrically connecting the external power supply PS and the charging circuit 13. Similarly to the first connection path 51 and the second connection path 52, the charging path 50 is also arranged away from the third connection path 53 by a set distance or more. Similarly to the set distance between the third connection path 53 and each of the first connection path 51 and the second connection path 52, the set distance between the charging path 50 and the third connection path 53 is set to be larger than the distance required for electrically insulating the third connection path 53 and the charging path 50. The charging path 50 illustrated in Fig. 3 extends from a portion of the junction box 132 on the surface width direction first side Y1 toward the surface width direction first side Y1. According to the present configuration, the charging path 50 is arranged at a position farther from the second arithmetic processing device 4 than from the junction box 132 as viewed in the orthogonal direction Z. Therefore, the second arithmetic processing device 4 is hardly affected by electromagnetic noise that is transmitted through the charging path 50 directly or via the third connection path 53.

### [Embodiment 2]

Details of a power conversion unit 100 of Embodiment 2 will be described with reference to Figs. 5 to 7. The power conversion unit 100 of Embodiment 2 is different from the power conversion unit 100 of Embodiment 1 in the positions of a power conversion circuit 1 and a second arithmetic processing device 4 with respect to a cooling member 21. In the following description, differences between the power conversion unit 100 of Embodiment 2 and the power conversion unit 100 of Embodiment 1 will be described, and description of other points will be omitted.

In the present embodiment, as illustrated in Figs. 5 to 7, the power conversion circuit 1 and the second arithmetic processing device 4 are arranged with respect to the cooling member 21. Note that in Figs. 5 to 7, the connection structure 5 is not illustrated in order to easily grasp the positions of the power conversion circuit 1 and the second arithmetic processing device 4. The connection structure 5 is arranged with respect to the cooling member 21 in the same manner as described in Embodiment 1.

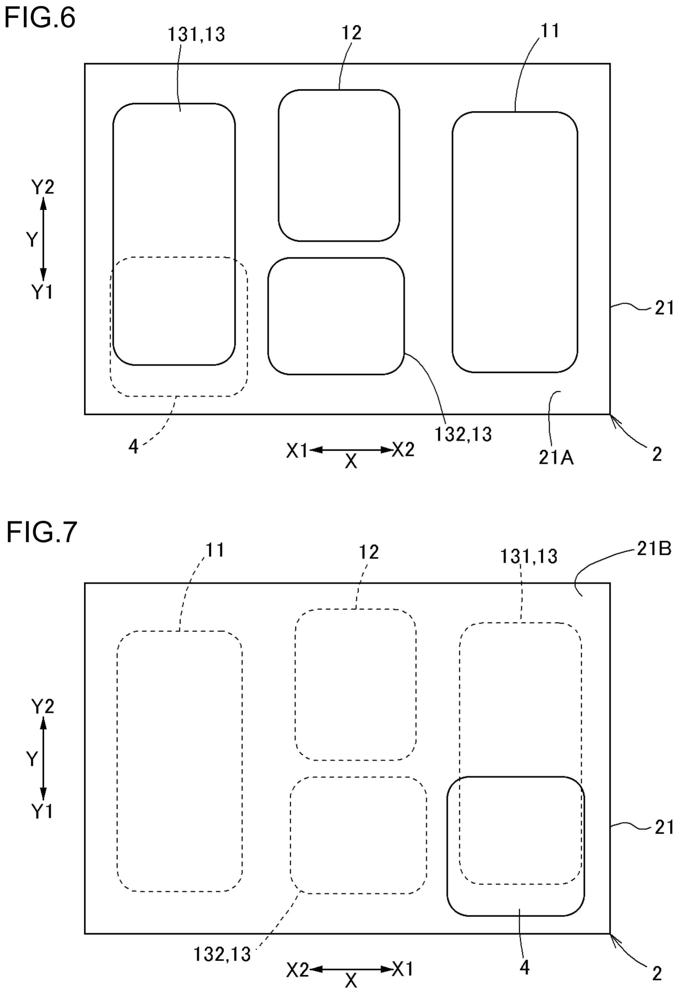

In the present embodiment, as illustrated in Figs. 5 and 6, the power conversion circuit 1 is arranged on a first surface 21A of the cooling member 21, and as illustrated in Fig. 7, the second arithmetic processing device 4 is arranged on a second surface 21B of the cooling member 21. According to the present configuration, the power conversion circuit 1 serving as a noise source of the second arithmetic processing device 4 can be collectively arranged on the first surface 21A. Therefore, it is possible to arrange the respective configurations in the power conversion circuit 1 in ascending order of the magnitude of influence on the second arithmetic processing device 4 as it proceeds from a position close to the second arithmetic processing device 4 to a position away from the second arithmetic processing device 4 with respect to the transmission path length of electromagnetic noise. In the example illustrated in Figs. 5 to 7, a charging circuit 13 is arranged at a position closest to the second arithmetic processing device 4, and a DC voltage conversion circuit 12 and an inverter circuit 11 are arranged at positions further from the second arithmetic processing device 4 in this order. In addition, in the cooling member 21 illustrated in Figs. 5 to 7, since all the configurations included in the power conversion circuit 1 are arranged on the first surface 21A, the dimension of the in-surface direction first side X1 is secured to be larger than that of the cooling member 21 of Embodiment 1. Also in this respect, in the power conversion unit 100 of Embodiment 2, regarding the transmission path length electromagnetic noise, the second arithmetic processing device 4 is easily arranged at a position sufficiently away from each configuration in the power conversion circuit 1.

### [Other embodiments]

Next, other embodiments of the power conversion unit 100 will be described.

In the above embodiments, it has been described that the vehicle drive device TA includes the rotary electrical machine M and the motive power transmission mechanism DR. Here, the vehicle drive device TA may be configured for a hybrid vehicle further including an internal combustion engine.

(2) In the above embodiments, it has been described that the in-vehicle power storage device B includes the in-vehicle battery and the capacitor. However, the in-vehicle power storage device B may include only the in-vehicle battery or only the capacitor, or may be another power storage device or the like.

(3) In the above embodiments, it has been described that the low-voltage battery LB is configured in the same manner as a DC power supply including a rechargeable secondary battery such as a lithium ion battery, an electric double layer capacitor, or the like. However, the low-voltage battery LB may include a lead-acid battery.

(4) In the above embodiments, it has been described that the driving support unit DAS performs automated driving. However, the driving support unit DAS may be configured to only assist the driver or to assist the driver in combination with automated driving.

(5) In the above embodiments, it has been described that cooling water is used as the refrigerant. However, the refrigerant may be another refrigerant such as an air conditioner refrigerant.

(6) In the above embodiments, it has been described that the DC voltage conversion circuit 12 performs power conversion for stepping down the DC power stored in the high-voltage battery HB. However, the DC voltage conversion circuit 12 may perform power conversion for boosting the voltage of the DC power stored in the high-voltage battery HB. In this case, the DC power boosted by the DC voltage conversion circuit 12 is supplied to the rotary electrical machine M, for example.

(7) In the above embodiments, it has been described that the power conversion circuit 1 includes the DC voltage conversion circuit 12. However, the DC voltage conversion circuit 12 is not an essential configuration in the power conversion circuit 1, and the power conversion circuit 1 may not include the DC voltage conversion circuit 12.

(8) In the above embodiments, it has been described that the first surface 21A and the second surface 21B of the cooling member 21 are both rectangular as viewed in the orthogonal direction Z. However, each of the first surface 21A and the second surface 21B may have a polygonal shape or a circular shape as viewed in the orthogonal direction Z. Here, the polygonal shape as viewed in the orthogonal direction Z includes a shape in which corners constituting the polygonal shape are curved.

(9) In the above embodiments, it has been described that the first connection path 51 and the second connection path 52 are bus bars. However, the first connection path 51 and the second connection path 52 may be power lines other than the bus bars.

(10) In the above embodiments, it has been described that the power conversion unit 100 includes the second arithmetic processing device 4 that performs processing equivalent to that of the first arithmetic processing device C. Here, the second arithmetic processing device 4 may continuously perform arithmetic processing even in a case where the first arithmetic processing device C malfunctions. According to the present configuration, even in a case where the first arithmetic processing device C malfunctions, driving support is continued by the second arithmetic processing device 4 without being interrupted.

(11) Note that the configurations disclosed in the above-described embodiments can be applied in combination with the configuration disclosed in another embodiment as long as there is no contradiction. Regarding other configurations, the embodiments disclosed in the present specification are merely examples in all respects. Therefore, various modifications can be appropriately made without departing from the gist of the present disclosure.

### [Summary of embodiments]

Hereinafter, a summary of the embodiments according to the power conversion unit 100 described above will be described below.

The power conversion unit (100) is the power conversion unit (100) that performs power conversion for the vehicle drive device (TA) including the rotary electrical machine (M) that is a drive source of the vehicle (V), the power conversion unit (100) includes: the power conversion circuit (1) including at least one of the inverter circuit (11) that performs conversion between DC power and AC power between the rotary electrical machine (M) and the in-vehicle power storage device (B), the DC voltage conversion circuit (12) that performs voltage conversion of DC power of the in-vehicle power storage device (B), and the charging circuit (13) that supplies power of the external power supply (PS) to the in-vehicle power storage device (B) to charge the in-vehicle power storage device (B); the cooling device (2) that cools the power conversion circuit (1); and the case (3) that accommodates the power conversion circuit (1) and the cooling device (2), the driving support arithmetic processing device (4) that performs arithmetic processing for supporting driving of the vehicle (V) is disposed in the case (3), and the driving support arithmetic processing device (4) is cooled by the cooling device (2).

According to the present configuration, the driving support arithmetic processing device (4) can also be cooled using the cooling device (2) for cooling the power conversion circuit (1). Therefore, it is easy to reduce the size and cost of the vehicle (V) as compared with a configuration in which the driving support arithmetic processing device (4) is provided in a unit different from the power conversion unit (100). In addition, since the driving support arithmetic processing device (4) and the power conversion circuit (1) are disposed in the same case (3), the transmission path of the control signal generated by the driving support arithmetic processing device (4) to the power conversion circuit (1) is easily simplified, and the delay in transmission of the control signal is easily reduced.

Here, it is preferable that the power conversion circuit (1) includes the inverter circuit (11) and the charging circuit (13), and the driving support arithmetic processing device (4) is arranged at a position farther from the inverter circuit (11) than from the charging circuit (13) with respect to the transmission path length of electromagnetic noise.

According to the present configuration, with respect to the transmission path length of electromagnetic noise, the driving support arithmetic processing device (4) is arranged at a position away from the inverter circuit (11) that may generate a large amount of electromagnetic noise. Therefore, it is possible to reduce the influence of the electromagnetic noise on the driving support arithmetic processing device (4) during operation of the vehicle (V). On the other hand, since the charging circuit (13), which often operates while the vehicle (V) is stopped, is arranged at a position closer to the driving support arithmetic processing device (4) than the inverter circuit (11) is, the driving support arithmetic processing device (4) is less likely to be affected by electromagnetic noise from the charging circuit (13) while the vehicle (V) is traveling. Therefore, since the inverter circuit (11) and the charging circuit (13) can be efficiently arranged in the space around the driving support arithmetic processing device (4), the entire power conversion unit (100) can be easily downsized.

In addition, it is preferable that the cooling device (2) includes the cooling member (21) in which the flow path (22) of the refrigerant is formed, the driving support arithmetic processing device (4) is attached to the first surface (21A) of the cooling member (21), the inverter circuit (11) and the DC voltage conversion circuit (12) are attached to the second surface (21B) of the cooling member (21) facing the side opposite to the first surface (21A), and the inverter circuit (11) and the DC voltage conversion circuit (12) are arranged at positions not overlapping with the driving support arithmetic processing device (4) as viewed in the orthogonal direction (Z) along the direction orthogonal to the first surface (21A).

According to the present configuration, with respect to the transmission path length of electromagnetic noise, the driving support arithmetic processing device (4) can be efficiently arranged at a position away from the inverter circuit (11) and the DC voltage conversion circuit (12) that may generate a large amount of electromagnetic noise. Therefore, the entire power conversion unit (100) can be easily downsized. In addition, since the driving support arithmetic processing device (4), the inverter circuit (11), and the DC voltage conversion circuit (12) are arranged so that the driving support arithmetic processing device (4) does not overlap with the inverter circuit (11) and the DC voltage conversion circuit (12) as viewed in the orthogonal direction (Z), the driving support arithmetic processing device (4) can be arranged apart from the inverter circuit (11) and the DC voltage conversion circuit (12) also from the viewpoint of the heat transfer path. Therefore, it is easy to appropriately cool the driving support arithmetic processing device (4).

Further, it is preferable that the first connection path (51) that electrically connects the power conversion circuit (1) and the in-vehicle power storage device (B) and the second connection path (52) that electrically connects the power conversion circuit (1) and the rotary electrical machine (M) are arranged away from the driving support arithmetic processing device (4) and the third connection path (53) including the signal line and the power line connected to the driving support arithmetic processing device (4) by a set distance set in advance or more.

According to the present configuration, since the third connection path (53) is arranged at the position separated from the first connection path (51) and the second connection path (52) by the set distance or more, the influence of the electromagnetic noise from the first connection path (51) and the second connection path (52) on the driving support arithmetic processing device (4) can be reduced.

The technology according to the present disclosure can be used in a power conversion unit that performs power conversion for a vehicle drive device including a rotary electrical machine that is a drive source of a vehicle.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A power conversion unit (100) performing power conversion for a vehicle drive device (TA) including a rotary electrical machine (M) that is a drive source of a vehicle (V), the power conversion unit (100) comprising:
a power conversion circuit (1) including at least one of an inverter circuit (11) that performs conversion between DC power and AC power between the rotary electrical machine (M) and an in-vehicle power storage device (B), a DC voltage conversion circuit (12) that performs voltage conversion of DC power of the in-vehicle power storage device (B), and a charging circuit (13) that supplies power of an external power supply (PS) to the in-vehicle power storage device (B) to charge the in-vehicle power storage device (B);
a cooling device (2) that cools the power conversion circuit (1); and
a case (3) that accommodates the power conversion circuit (1) and the cooling device (2),
a driving support arithmetic processing device (4) that performs arithmetic processing for supporting driving of the vehicle (V) being disposed in the case (3), and
the driving support arithmetic processing device (4) being cooled by the cooling device (2).

2. The power conversion unit (100) according to Claim 1,
wherein the power conversion circuit (1) includes the inverter circuit (11) and the charging circuit (13), and
the driving support arithmetic processing device (4) is arranged at a position farther from the inverter circuit (11) than from the charging circuit (13) with respect to a transmission path length of electromagnetic noise.

3. The power conversion unit (100) according to Claim 1 or 2,
wherein the cooling device (2) includes a cooling member (21) in which a flow path (22) of a refrigerant is formed,
the driving support arithmetic processing device (4) is attached to a first surface (21A) of the cooling member (21),
the inverter circuit (11) and the DC voltage conversion circuit (12) are attached to a second surface (21B) of the cooling member (21) facing a side opposite to the first surface (21A), and
the inverter circuit (11) and the DC voltage conversion circuit (12) are arranged at positions not overlapping with the driving support arithmetic processing device (4) as viewed in an orthogonal direction (Z) along a direction orthogonal to the first surface (21A).

4. The power conversion unit (100) according to any one of Claims 1 to 3, wherein a first connection path (51) that electrically connects the power conversion circuit (1) and the in-vehicle power storage device (B) and a second connection path (52) that electrically connects the power conversion circuit (1) and the rotary electrical machine (M) are arranged away from the driving support arithmetic processing device (4) and a third connection path (53) including a signal line and a power line connected to the driving support arithmetic processing device (4) by a set distance set in advance or more.
